# EUROPEAN PATENT APPLICATION

(11) **EP 4 753 088 A1**
(43) Date of publication of application: **03.06.2026**
(21) Application number: 25219584.7
(22) Date of filing: 28.11.2025
(51) Int. Cl.: H02B 1/28, H02B 1/56, H05K 5/02, H05K 7/20

(54) **AN OUTDOOR ENCLOSURE FOR ELECTRICAL EQUIPMENT AND A METHOD THEREOF**

(30) Priority: 29.11.2024 IN 202421093728
(71) Applicant: VERTIV ENERGY PRIVATE LIMITED, 400604 Thane Maharashtra (IN)
(72) Inventor: SALUNKE, Parag Ramrao, 412101 Pune (IN); GANPULE, Vaibhav Sitaram, 400607 Thane West (IN); PURANIK, Santosh Vasant, 411041 Pune (IN)
(74) Representative: Cousens, Nico

(57) **Abstract**

The present invention discloses an outdoor enclosure (100) for electrical equipment (200). The enclosure (100) comprises an inlet air diverter door assembly (110), configured to allow fresh air to enter the enclosure while preventing the ingress of water and dust, and an outlet air diverter door assembly (120), configured to efficiently exhaust hot air generated within the enclosure while minimizing back pressure and noise levels. The inlet air diverter door assembly (110) and the outlet air diverter door assembly (120) cooperate to maintain the enclosure's internal temperature within acceptable operational limits, even under a heat load of up to 5.4 kW.

## Description

### TECHNICAL FIELD

The present disclosure relates to the field of enclosures. More particularly, the present disclosure provides an outdoor enclosure for electrical equipment protection and environmental management.

### BACKGROUND

Outdoor enclosures are essential for housing sensitive electrical equipment in industries such as telecommunications, power distribution, thermal distribution units, and data processing, where equipment reliability and protection are critical. The integration of an air ventilation system and exhaust system within the enclosure is particularly important, as it helps manage heat generated by electrical equipment. Overheating can lead to equipment malfunction or failure, so proper airflow ensures that components remain within safe operating temperatures. Additionally, ventilation systems help maintain optimal performance and extend the lifespan of equipment by preventing thermal stress and the buildup of heat-sensitive contaminants inside the enclosure.

### SUMMARY OF THE INVENTION

This summary is provided to introduce aspects related to an outdoor enclosure for electrical equipment protection and environmental management.

In an aspect, an outdoor enclosure for electrical equipment is disclosed. The outdoor enclosure comprises an inlet air diverter door assembly, configured to allow fresh air to enter the enclosure while preventing the ingress of water and dust, and an outlet air diverter door assembly, configured to efficiently exhaust hot air generated within the enclosure while minimizing back pressure and noise levels, wherein the inlet air diverter door assembly and the outlet air diverter door assembly cooperate to maintain the enclosure's internal temperature within acceptable operational limits, even under a heat load of up to 5.4 kW..

In an aspect, the inlet air diverter door assembly comprises a series of diverter plates oriented to direct incoming air towards the electrical equipment, and channel water jets downward and out of the enclosure to prevent water entry.

In an aspect, the inlet air diverter door assembly further includes a filter element positioned to optimize airflow, diverter plates that deflect water jets away from the filter element, ensuring that the water does not reach the electrical equipment.

In an aspect, the distance between the filter element and the electrical equipment is less than 75 mm, and the diverter assembly is optimized for high suction pressures created by internal fans.

In another aspect, the outlet air diverter door assembly comprises diverter plates arranged to minimize noise and back pressure and an outlet hood configured to direct exhaust air directly into the environment, preventing water ingress. Further, the outlet air diverter assembly is coupled with a centrifugal fan to enhance airflow and reduce noise.

In an aspect, the inlet and outlet diverter door assembly are configured without requiring specialized tooling, enabling cost-effective manufacturing.

In yet another aspect, the inlet air diverter door assembly includes a multi-layer filtration system comprising a coarse pre-filter to block larger debris and insects, a fine particulate filter configured to meet HEPA (High-Efficiency Particulate Air) standards or equivalent standards for air cleanliness, and a water-resistant barrier layer to deflect high-pressure water jets.

In another aspect, the outlet air diverter door assembly includes an acoustic insulation layer positioned around the exhaust channel to dampen sound waves generated by airflow turbulence, and aerodynamic fins within the outlet hood to streamline airflow and reduce noise levels.

In an aspect, the high suction pressures created by internal fans are optimized using a computational fluid dynamics (CFD) model to enhance cooling efficiency and minimize pressure drop across the system.

In another aspect, the centrifugal fan is integrated with variable-speed control to adapt to dynamic thermal loads, reducing energy consumption under low-heat conditions.

In yet another aspect, internal layout with the enclosure is configured such that critical electrical components are positioned in a central thermal zone for uniform cooling, and cable management pathways are insulated from airflow channels to prevent thermal interference.

In yet another aspect, the outdoor enclosure door further comprising a drainage system integrated into the inlet and outlet air diverter door assembly to collect condensate or accumulated water and expel/drain water that might accumulate within the enclosure during operation.

In an aspect, the diverter plates are coated with a hydrophobic material to enhance water deflection and self-cleaning properties. In another aspect, the enclosure material comprises a corrosion-resistant alloy or composite material with high thermal conductivity to improve passive heat dissipation.

In an aspect, the outlet air diverter door assembly includes an anti-reverse flow valve to prevent backdraft from environmental conditions such as wind gusts.

In an aspect, the inlet air diverter assembly includes an automated cleaning mechanism using air jets or vibrations to dislodge dust and debris from the filter element.

In an aspect, the outlet hood is configured with a curved geometry to prevent rainwater pooling and enhance environmental durability.

In an aspect, a method for cooling an outdoor enclosure housing electrical equipment is provided. The method comprises the steps of (i) providing an inlet air diverter door assembly that allows fresh air to enter the enclosure while preventing water and dust ingress, (ii) providing an outlet air diverter door assembly that exhausts hot air generated by the electrical equipment while reducing noise and preventing water ingress, and (iii) maintaining internal temperatures within safe operational limits under a heat load of up to 5.4 kW.

In an aspect, the method includes arranging the diverter plates within both the inlet and outlet diverter door assemblies in a particular orientation to achieve optimized airflow, reduced noise and back pressure, and protection against water ingress.

In an aspect, the method further includes dynamically adjusting the orientation of the diverter plates using motorized actuators to optimize airflow based on real-time environmental conditions.

Other aspects and advantages of the disclosure will become apparent from the following description, taken in conjunction with the accompanying drawings, illustrating by way of example the principles of the disclosure.

### BRIEF DESCRIPTION OF THE DRAWINGS

The accompanying figures of the drawing, which are included to provide a further understanding of general aspects of the system/method, are incorporated in and constitute a part of this specification. These illustrative aspects of the system/method, and together with the detailed description, explain the principles of the system. No attempt is made to show structural details in more detail than is necessary for a fundamental understanding of the system and various ways in which it is practiced. The following figures of the drawing include:
**FIG 1A** illustrates a perspective view of the inlet door assembly on an outdoor enclosure, highlighting the inlet diverter plates configured to allow airflow into the enclosure while deflecting water and dust;
**FIG 1B** illustrates an alternative perspective view of the inlet door assembly on the outdoor enclosure;
**FIG 2A** illustrates an internal view of the inlet door assembly, focusing on the filter element positioned to capture particulates and ensure clean air enters the enclosure;
**FIG 2B** illustrates another view of the inlet door assembly with the filter element, demonstrating its placement for optimal filtration of incoming air;
**FIG 3A** illustrates a front view of the inlet door assembly on the enclosure, showing the inlet diverter plates arranged to guide airflow and block contaminants;
**FIG 3B** illustrates a side view of the inlet door assembly, showing the filter element positioned to trap dust and particles before air enters the enclosure;
**FIG 3C** illustrates another side view of the inlet door assembly, emphasizing the positioning of the filter element for effective filtration and airflow management;
**FIG 4** illustrates a cross-sectional view of the enclosure, displaying the inlet door assembly, internal fans, and electrical components, with the inlet diverter plates directing airflow while deflecting contaminants;
**FIG 5A** illustrates a detailed view of the inlet diverter plates in a staggered configuration, configured to optimize airflow and prevent contaminants from entering;
**FIG 5B** illustrates a side view of the inlet door assembly, highlighting the staggered assembly of the inlet diverter plates and filter element for effective airflow control;
**FIG 5C** illustrates a close-up side view of the inlet door assembly, showing the staggered layout of the inlet diverter plates and the positioning of the filter element for optimal airflow;
**FIG 6A** illustrates a perspective view of the outlet door assembly on the enclosure, showing the outlet diverter plates configured to expel hot air while minimizing noise and blocking contaminants;
**FIG 6B** illustrates an alternative perspective view of the outlet door assembly, focusing on the layout of the outlet diverter plates to direct airflow effectively;
**FIG 7A** illustrates a rear view of the outlet door assembly with a large circular exhaust port for expelling hot air to regulate internal temperature;
**FIG 7B** illustrates a perspective view of the enclosure showing the exhaust port on the outlet assembly for efficient hot air expulsion;
**FIG 8A** illustrates a side view of the enclosure showing the exhaust port on the outlet panel, configured to facilitate airflow out of the enclosure;
**FIG 8B** illustrates a front view of the outlet assembly on the enclosure displaying the outlet diverter plates in a horizontal assembly to guide airflow and reduce noise;
**FIG 8C** illustrates another side view of the outlet door assembly, showing the exhaust port and panel for effective ventilation and environmental protection;
**FIG 9** illustrates a cross-sectional view of the enclosure, featuring internal electrical components and the outlet assembly with the exhaust port and outlet diverter plates, arranged to expel hot air and protect internal components;
**FIG 10A****,** **10B****,** **10C** **and** **10D** illustrates a component assembly of door of an outdoor enclosure; and
**FIG 11** illustrates a method for cooling an outdoor enclosure housing electrical equipment.

In the appended figures, similar components and/or features may have the same numerical reference label. Further, various components of the same type may be distinguished by following the reference label with a letter. If only the first numerical reference label is used in the specification, the description is applicable to any one of the similar components and/or features having the same first numerical reference label irrespective of the suffix.

### DESCRIPTION OF THE INVENTION

Illustrative embodiments are described with reference to the accompanying drawings. Wherever convenient, the same reference numbers are used throughout the drawings to refer to the same or like parts. While examples and features of disclosed principles are described herein, modifications, adaptations, and other implementations are possible without departing from the scope of the disclosed embodiments. It is intended that the following detailed description be considered as exemplary only, with the true scope being indicated by the following claims.

Existing enclosure systems generally incorporate ventilation and cooling mechanisms to manage internal temperatures and protect against environmental exposure, but they encounter significant limitations impacting their performance and maintenance.

One major challenge in conventional enclosures is effective temperature management. Many current configurations rely on passive ventilation or active cooling solutions, such as axial fans or air conditioning systems, to control internal temperatures. Passive systems often fall short in managing high thermal loads, while active systems are associated with higher energy consumption, operational noise, and frequent maintenance requirements. These systems also struggle to provide consistent cooling, especially in compact enclosures with varying or elevated heat demands.

Ingress protection poses another critical issue in outdoor enclosures. To prevent contamination, many enclosures are configured to meet ingress protection (IP) standards, such as IP55, which shield against water and dust. However, typical configurations often rely on simple filters or seals, which can clog or deteriorate over time, reducing effectiveness. Many enclosures also lack robust water deflection mechanisms, leaving them susceptible to leaks during heavy rainfall or high-pressure washing, which risks equipment damage.

Airflow efficiency and noise control are also challenging aspects in current ventilation configurations. Systems using traditional axial fans frequently produce high levels of noise and back pressure. This back pressure can impede airflow efficiency, creating hotspots within the enclosure that degrade electronic components. Additionally, noise generated from airflow turbulence can be disruptive in settings with noise restrictions, such as residential or urban areas.

Structural durability and ease of maintenance further limit the performance of existing enclosures. Many configurations require specialized tools and complex assembly, making manufacturing and maintenance both costly and time-consuming. Standard materials used in conventional enclosures may lack sufficient resistance to corrosion, UV exposure, and thermal expansion, reducing their lifespan in harsh outdoor environments. Moreover, most configurations lack modular components, complicating repairs and extending downtime during maintenance.

Filtration systems in traditional enclosures also present limitations. Commonly, enclosures employ single-layer filters that block large debris but are less effective at capturing fine particulates. These filters can quickly become clogged, reducing internal air quality and increasing the risk of equipment contamination. Routine maintenance for these filters can be labor intensive and costly, as they often require frequent cleaning or replacement.

Therefore, there is a need for an outdoor enclosure for electrical equipment and a method thereof that alleviates the aforementioned drawbacks. The present disclosure provides outdoor enclosure configured for housing electrical equipment and provides effective ventilation systems to regulate internal temperatures, ensuring reliable operation of the equipment while protecting against environmental elements such as water, dust, and varying temperatures. This enclosure can combine effective cooling, environmental protection, and structural durability, allowing for the safe and reliable operation of sensitive equipment. The disclosure addresses key challenges associated with temperature control, ingress protection, noise reduction, and maintenance efficiency.

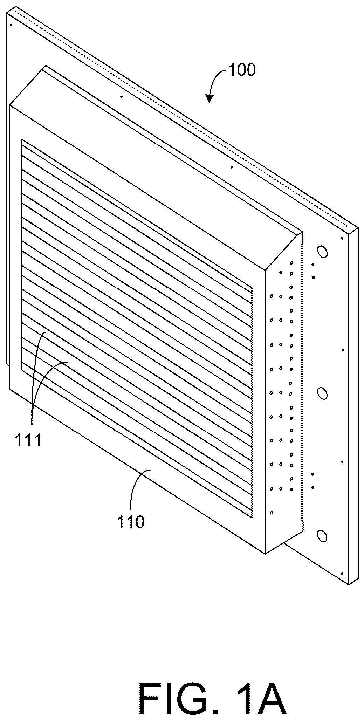

FIG 1A shows an exterior perspective view of an inlet air diverter door assembly (110) of the outdoor enclosure (100). The outdoor enclosure includes an inlet air diverter door assembly (110) and an outlet air diverter door assembly (120). The inlet air diverter door assembly (110) and the outlet air diverter door assembly (120) cooperate to maintain the enclosure's internal temperature within acceptable operational limits, even under a heat load of up to 5.4 kW.

The inlet air diverter door assembly (110) may be configured to allow fresh air to enter the enclosure while preventing the ingress of water and dust. In an embodiment, the inlet air diverter door assembly (110) comprises a series of diverter plates (111) oriented to direct incoming air towards the electrical equipment (200), and channel water jets downward and out of the enclosure to prevent water entry. The inlet diverter plates (111) are visible on the surface, arranged in a horizontal, parallel layout. These plates (111) are configured to allow fresh air into the enclosure while deflecting water and dust away from sensitive components and electrical equipment (200) inside the enclosure.

In an embodiment, a filter element (113) may be positioned within the inlet air diverter door assembly (110) to optimize airflow while blocking contaminants. In one embodiment, the inlet air diverter door assembly (110) can include a multi-layer filtration system, which may comprise a coarse pre-filter that may block larger debris, insects, and particulates. Further, the multi-layer filtration system comprises a fine particulate filter that may meet HEPA or equivalent standards for cleaner air quality and a water-resistant barrier layer that may provide an additional layer of protection by deflecting high-pressure water jets. In an embodiment an automated cleaning mechanism may be implemented, which may use air jets or vibrations, can dislodge dust and debris from the filter element (113), reducing maintenance frequency and maintaining airflow efficiency.

In an embodiment, the distance between the filter element (113) and the electrical equipment (200) can be kept below 75 mm, optimizing the airflow path for high suction pressures that may be generated by internal fans (210) within the enclosure.

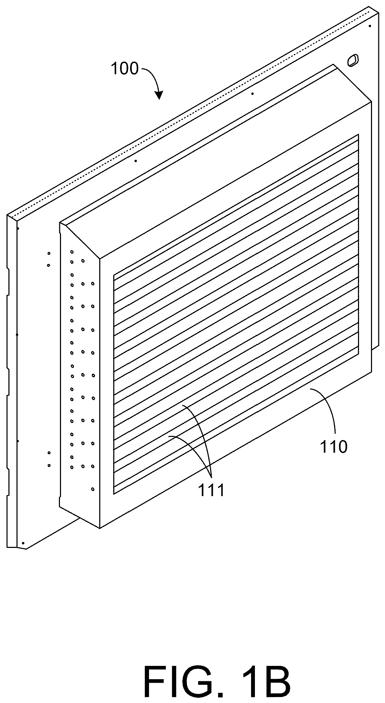

FIG 1B presents another perspective view of the inlet air diverter door assembly (110) from a different angle, highlighting the layout and positioning of the inlet diverter plates (111). These plates maintain a similar assembly as in Figure 1A, allowing airflow to enter while providing protection against environmental contaminants.

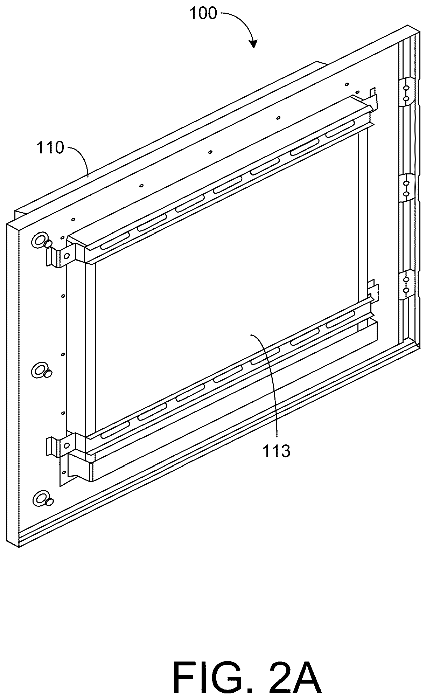

FIG 2A offers an internal view of the inlet air diverter door assembly (110), with a focus on the filter element (113) positioned within. This filter element (113) is configured to capture fine particulates, ensuring that only clean air reaches the equipment inside the enclosure. The placement of the filter element provides an additional layer of protection.

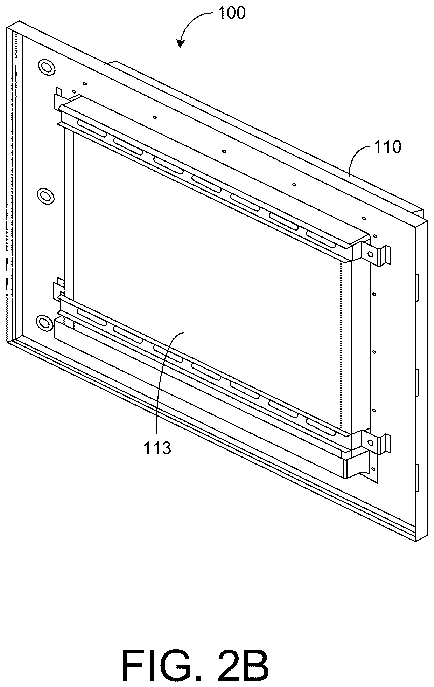

FIG 2B shows a similar internal view of the inlet door assembly (110) as Figure 2A, with the filter element (113) positioned centrally within the assembly. This configuration ensures effective air filtration before air enters the enclosure, supporting the integrity of the equipment housed inside.

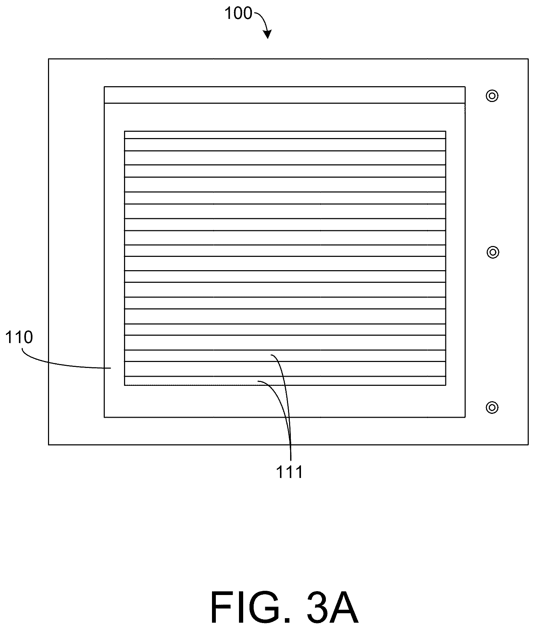

FIG 3A shows a front view of the inlet door assembly (110) on the enclosure (100), showing the assembly of the inlet diverter plates (111) on the external surface. The parallel, staggered layout of the plates helps guide airflow while preventing contaminants from entering.

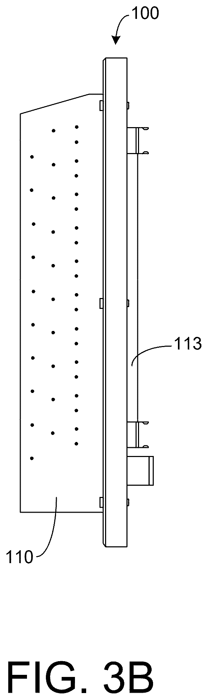

FIG 3B shows a side view of the inlet door assembly (110) revealing the positioning of the filter element (113) relative to the enclosure. The orientation allows for optimal airflow while ensuring that the filter element captures dust and other airborne particles before they reach the interior of the enclosure.

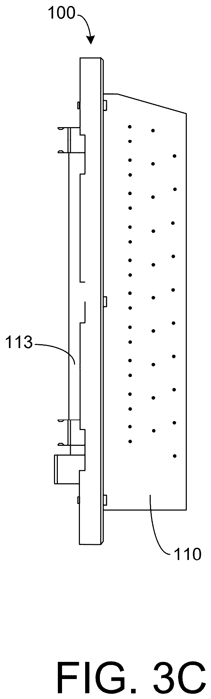

FIG 3C provides an alternative side view of the inlet assembly (110) similar to Figure 3B, with the filter element (113) visible inside the assembly. This configuration emphasizes the layered protective approach for managing airflow and preventing contamination of internal components.

In an embodiment, the outlet air diverter door assembly (120) may be configured to expel hot air generated by the enclosed equipment (200) efficiently, to minimize noise and back pressure. The outlet air diverter door assembly (120) comprises a plurality of diverter plates (121) arranged to minimize noise and back pressure. Further, an outlet hood may be configured to direct exhaust air directly into the environment, preventing water ingress.

Diverter plates (121) within the outlet air diverter door assembly (120) may be arranged to reduce back pressure while directing airflow with minimal turbulence, effectively managing noise levels. An outlet hood can ensure that hot air is directed out of the enclosure, also serving as a barrier to prevent water entry. The outlet hood may be configured with a curved geometry to prevent rainwater pooling and enhance environmental durability.

The outlet air diverter door assembly (120) can be equipped with a centrifugal fan (130) to enhance airflow efficiency compared to conventional axial fan configurations. This centrifugal fan (130) may include a variable-speed control to adapt to changing thermal loads, allowing for energy conservation during low-heat conditions.

In some embodiments, additional acoustic insulation may be positioned around the exhaust channel to dampen noise created by airflow turbulence, and aerodynamic fins may be integrated within the outlet hood to further streamline airflow and reduce noise levels. In an embodiment, the high suction pressures created by internal fans (210) are optimized using a computational fluid dynamics (CFD) model to enhance cooling efficiency and minimize pressure drop across the system.

The enclosure (100) may be configured with structural durability in mind. The material of the enclosure can comprise a corrosion-resistant alloy or composite with high thermal conductivity to promote passive heat dissipation. To improve water deflection and maintain cleanliness, the diverter plates (111) in the inlet assembly may be coated with a hydrophobic material, which can enhance water shedding and provide self-cleaning properties under various environmental conditions.

Additionally, the outlet air diverter door assembly (120) may include an anti-reverse flow valve to prevent backdraft caused by external environmental factors. In an embodiment, the anti-reverse flow valve may be designed to prevent undesirable backflow, such as when external environmental factors (like wind gusts) cause air to flow in the opposite direction, disrupting the intended airflow. The valve ensures that the airflow remains stable within the enclosure by blocking any reverse airflow that could compromise the system's performance or efficiency. The valve helps maintaining the integrity of the system by allowing air to flow in one direction while preventing any reverse or backdraft conditions that could destabilize the process.

The enclosure (100) can include an internal thermal configuration that may be optimized for uniform cooling. Critical electrical components (200) can be positioned within a central thermal zone, where cooling efficiency may be maximized. To prevent thermal interference, cable management pathways may be insulated and isolated from primary airflow channels.

A condensate drainage system may be integrated within the inlet (110) and outlet (120) air diverter door assembly to collect and expel any moisture that might accumulate, thereby preventing damage or corrosion inside the enclosure.

The diverter door assembly (110, 120) may be configured to be manufactured without requiring specialized tooling, allowing for cost-effective production. The use of modular components in both the inlet and outlet diverter assemblies can facilitate straightforward assembly and replacement, enhancing ease of maintenance and reducing downtime during service.

In addition to the multi-layer filtration system, the diverter plates (111, 121) may optionally be coated with a sound-dampening material to reduce noise while maintaining structural integrity under high airflow velocities. The inlet diverter plates (111) can also be configured with adjustable angles to fine-tune the airflow direction for targeted cooling of high-heat components.

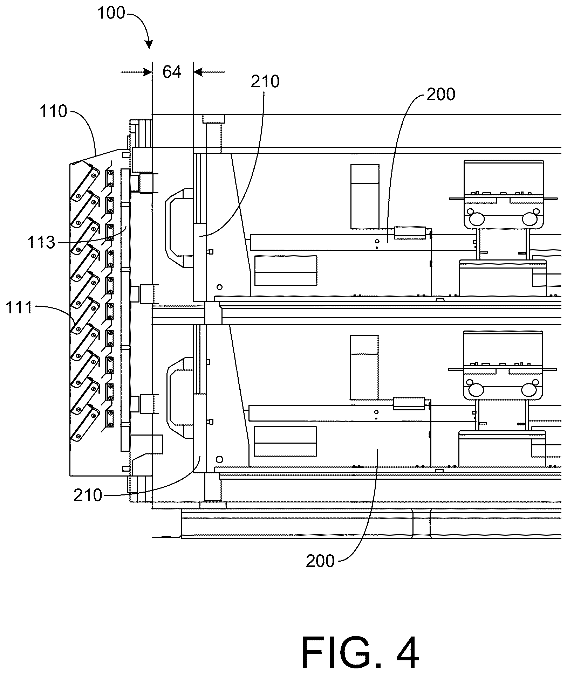

FIG 4 presents a cross-sectional view of the enclosure (100) showcasing the internal layout and airflow system. The inlet door assembly (110) includes the filter element (113) and inlet diverter plates (111), which are configured to direct incoming air toward the internal electrical equipment (200) while deflecting water and dust. Internal fans (210) create high suction pressures to enhance airflow towards the equipment (200), which is stacked in layers inside the enclosure, providing targeted cooling for each component.

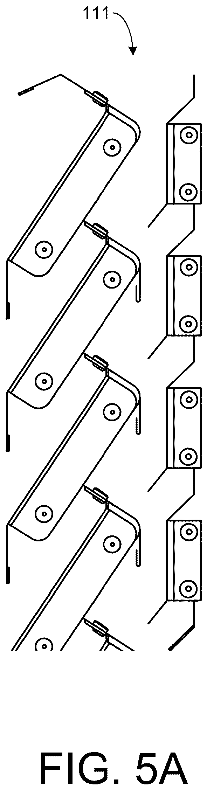

FIG 5A shows a detailed side view of the inlet diverter plates (111) in a staggered configuration. This assembly helps to control and direct incoming airflow efficiently while preventing contaminants from entering the enclosure. The staggered pattern optimizes airflow by reducing turbulence and maintaining steady air movement through the inlet assembly.

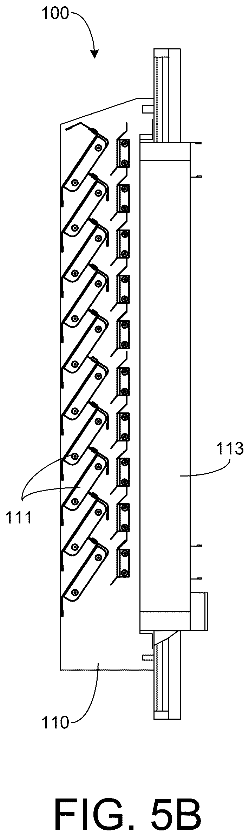

FIG 5B provides a side view of the inlet door assembly (110), showing the placement of the inlet diverter plates (111) and filter element (113). The diverter plates (111) guide incoming air toward the filter element (113) while blocking water and dust. The configuration maintains a clean airflow path to the internal components, ensuring protection and cooling within the enclosure (100).

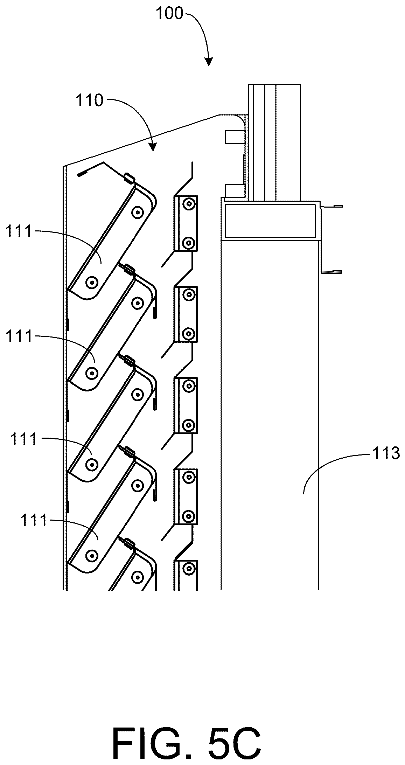

In FIG 5C, a close-upside view of the inlet door assembly (110) further highlights the staggered layout of the inlet diverter plates (111) and the positioning of the filter element (113). This assembly enhances airflow control and contributes to the effective filtration of contaminants before they reach the sensitive equipment inside the enclosure.

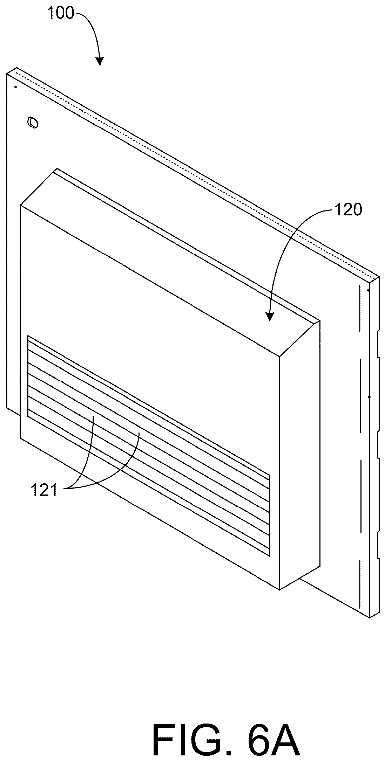

FIG 6A shows a perspective view of the outlet air diverter door assembly (120) on the enclosure (100), showing the outlet diverter plates (121) positioned on the panel. These plates are configured to direct hot air out of the enclosure, minimizing back pressure and noise. The angled layout of the diverter plates (121) facilitates efficient air expulsion and prevents environmental ingress.

In an embodiment, the inlet diverter plates (111) are configured to channel fresh air toward internal equipment (200) while deflecting water jets and dust away from sensitive components. The outlet diverter plates (121) are configured to efficiently expel hot air, minimizing noise and back pressure, and incorporate features to prevent water ingress. In another embodiment, the inlet diverter plates (111) may be configured with adjustable angles, enabling fine-tuning of the airflow direction toward specific zones within the enclosure. This adjustability supports targeted cooling for high-heat components (200), enhancing cooling efficiency in areas with higher thermal demands.

In an operative configuration, the diverter assembly for outdoor enclosures (100) includes inlet diverter plates (111) positioned to direct fresh air toward internal equipment (200) while simultaneously deflecting water jets and dust. This configuration ensures that airflow reaches critical components without allowing contaminants to enter the protected space. Additionally, outlet diverter plates (121) are positioned to expel hot air generated within the enclosure, minimizing noise and back pressure, while incorporating features that prevent water ingress. The inlet diverter plates may also have adjustable angles, allowing precise airflow direction toward specific areas, thereby enhancing cooling for high-heat components.

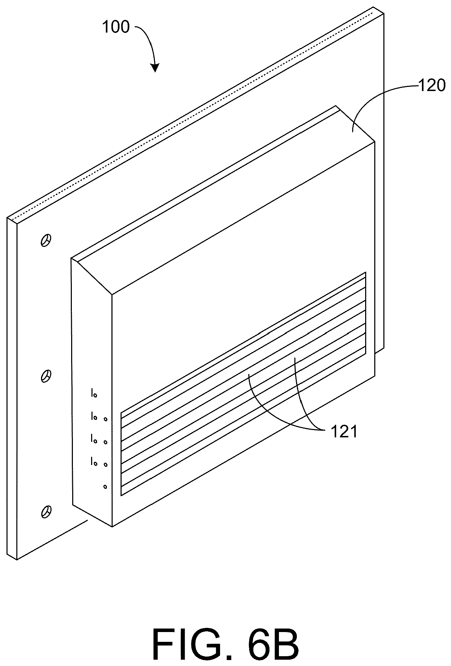

FIG 6B provides an alternative perspective view of the outlet door assembly (120), with the outlet diverter plates (121) arranged similarly to those in FIG 6A. This view emphasizes the positioning and alignment of the plates on the outlet panel, allowing for optimized airflow and noise reduction.

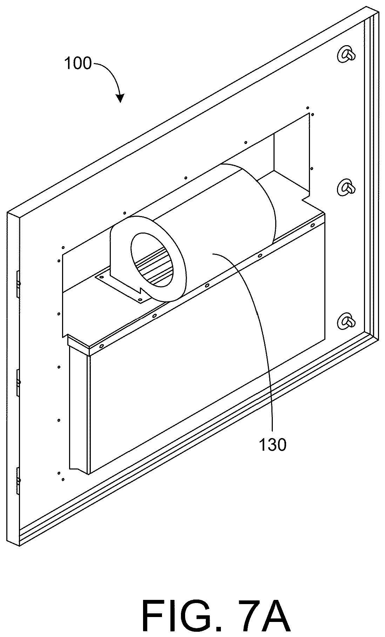

FIG 7A shows a rear view of the outlet air diverter door assembly (120) with a large circular opening labelled (130), which serves as a connection point for an exhaust fan or ventilation system. The outlet air diverter assembly (120) may be coupled with a centrifugal fan (130) to enhance airflow and reduce noise. The configuration allows efficient expulsion of hot air, maintaining the internal temperature of the enclosure (100) within operational limits. The outlet configuration supports cooling by facilitating airflow out of the enclosure.

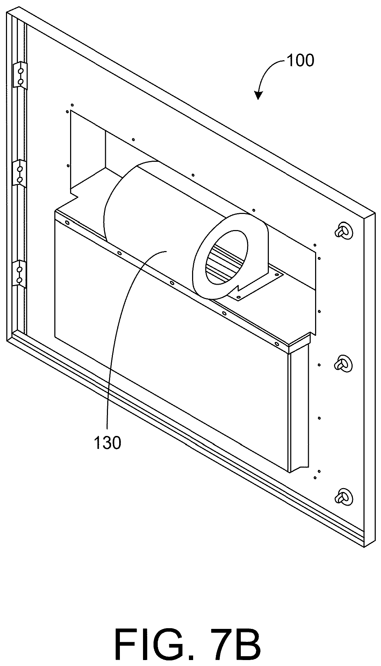

FIG 7B presents a perspective view of the enclosure (100) showing the rear side of the outlet assembly. The large circular component labelled (130) functions as a passage or duct, likely serving as an exhaust port for hot air. This component is positioned to allow efficient airflow out of the enclosure while helping maintain internal temperature control.

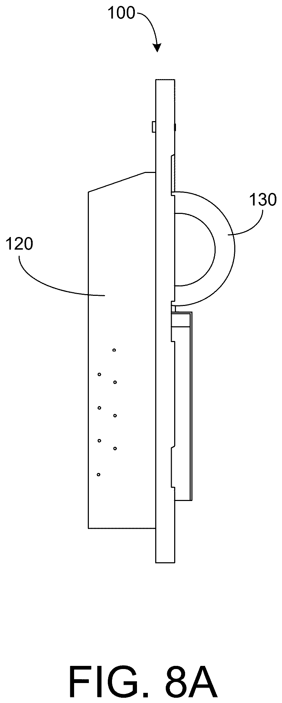

FIG 8A shows a side view of the enclosure (100), the outlet assembly is depicted with the outlet air diverter door assembly (120) and the circular exhaust port (130). This view emphasizes the positioning of the exhaust port (130) relative to the outlet air diverter door assembly (120) demonstrating how it facilitates the expulsion of hot air from the enclosure.

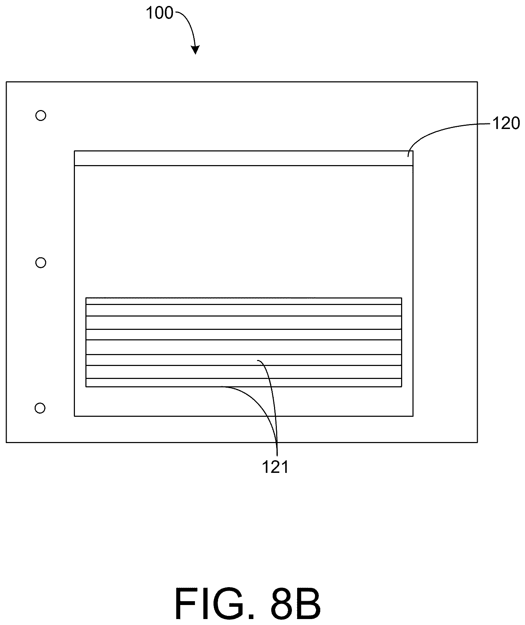

FIG 8B shows a front view of the outlet assembly on the enclosure (100) and highlights the outlet diverter plates (121) mounted on the outlet air diverter door assembly (120).These plates are arranged horizontally and configured to manage airflow, directing it outwards while reducing noise and preventing environmental ingress.

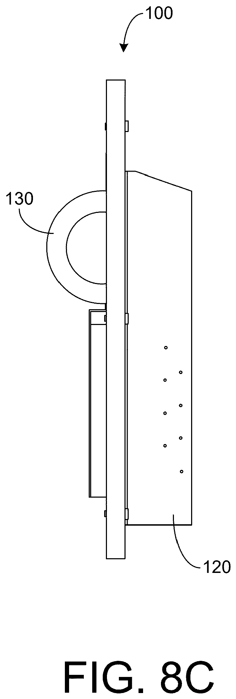

Similar to FIG 8A, FIG 8C shows a side view of the position of the exhaust port (130) on the outlet assembly, with the outlet air diverter door assembly (120) visible on the enclosure (100). This configuration supports effective ventilation while protecting against backflow and environmental contaminants.

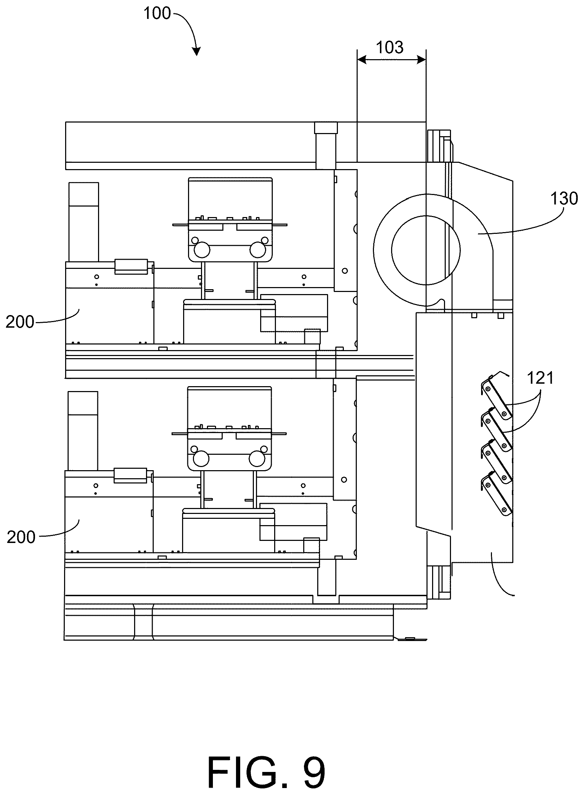

FIG 9 shows a cross-sectional view of the enclosure (100) and provides an overview of the internal layout, showing the placement of electrical components (200) and the airflow system. The outlet assembly features the exhaust port (130) and outlet diverter plates (121), which direct hot air out of the enclosure while ensuring a stable internal environment. The staggered layout of the plates (121) enhances airflow management and reduces back pressure.

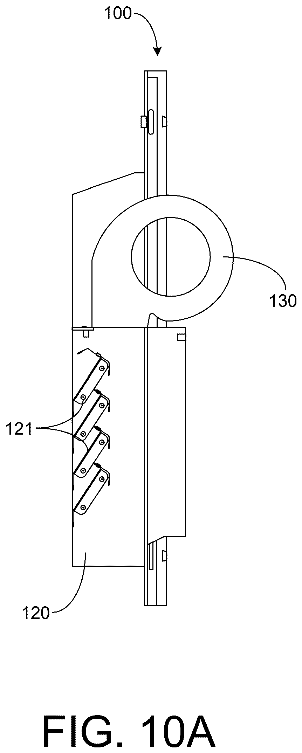

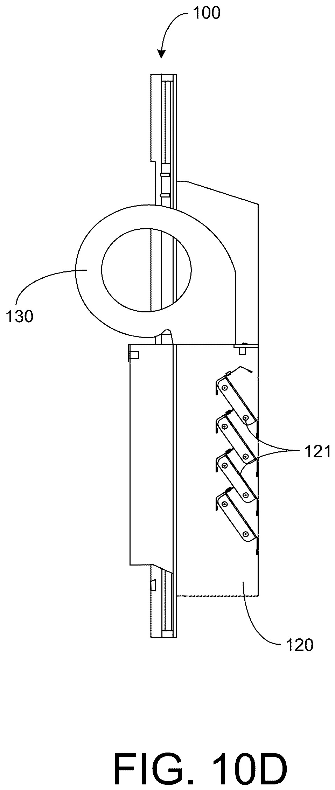

In FIG 10A, a side view of the assembly shows a large circular opening labelled as (130), which may serve as an airflow passage, potentially connecting to a fan or other ventilation system. An outlet air diverter door assembly (120), is shown with multiple diverter plates (121) arranged along its length. These diverter plates (121) are configured to direct airflow and deflect water and dust away from internal components, enhancing the enclosure's protective and cooling capabilities. The offset pattern of these diverter plates supports efficient airflow management by reducing back pressure and minimizing noise.

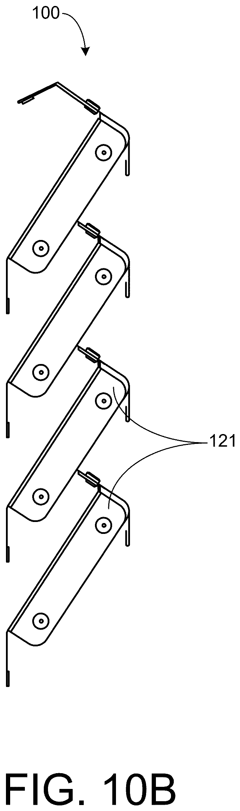

Figure 10B provides a detailed view of the diverter plates (121), showing them in a staggered or offset assembly. This configuration allows the plates to optimize airflow direction and prevent contaminants from entering the enclosure, contributing to the effective cooling of internal high-heat components.

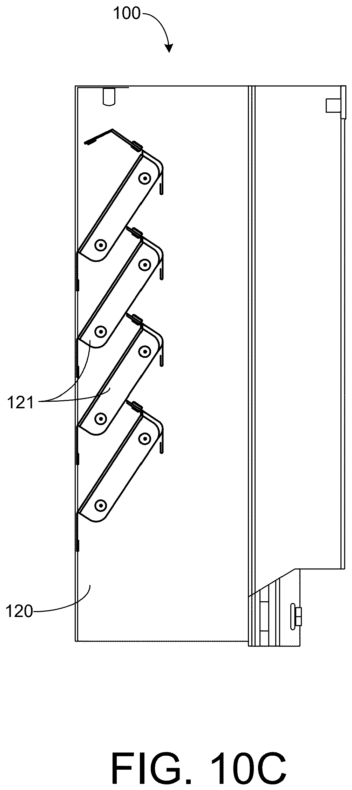

FIG 10C presents a front view of the outlet air diverter assembly (120), with the diverter plates (121) visibly arranged in the same staggered pattern. This view highlights the alignment and configuration of the diverter plates on the panel, demonstrating how they work together to manage airflow, deflect water, and protect internal equipment (200).

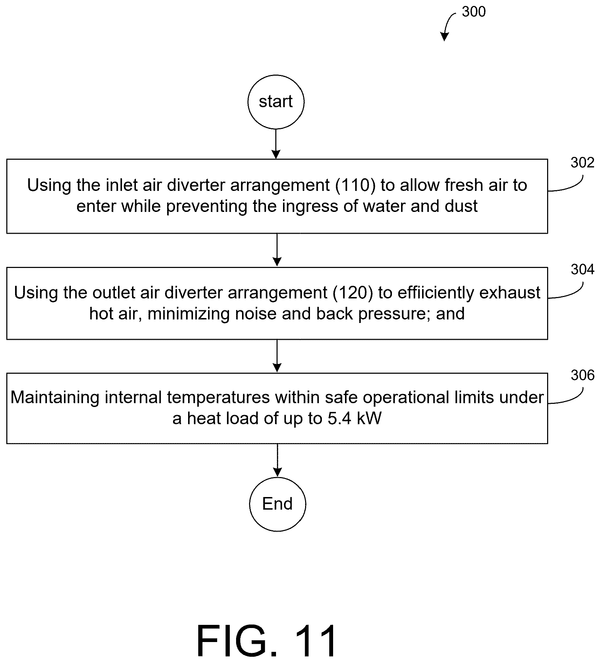

FIG 11 illustrate a flowchart that includes the steps involved in a method (300) for cooling the outdoor enclosure housing electrical equipment. The method (300) comprises the following steps:

At step (302), method (300) includes, using the inlet air diverter door assembly (110) to allow fresh air to enter while preventing the ingress of water and dust.

At step (304), method (300) includes, using the outlet air diverter door assembly (120) to efficiently exhaust hot air, minimizing noise and back pressure.

At step (306), method (300) includes, maintaining internal temperatures within safe operational limits under a heat load of up to 5.4 kW.

To optimize airflow efficiency, diverter plates (111, 121) may be arranged in specific orientations to minimize noise, reduce back pressure, and prevent water ingress. This cooling method can be further enhanced by dynamically adjusting the orientation of the diverter plates (111, 121) using motorized actuators to adapt to real-time environmental conditions.

Advantageously, the disclosure provides a robust solution for housing and protecting electrical equipment (200) in outdoor environments. By integrating both inlet (110) and outlet (120) air diverter door assembly, the system ensures effective temperature control and ventilation, maintaining internal conditions within safe operational limits. This configuration not only prevents the ingress of water and dust but also allows efficient heat dissipation, even under high thermal loads up to 5.4 kW, while minimizing noise and back pressure. The system's compliance with IP55 ingress protection standards further enhances its durability and reliability, making it suitable for harsh outdoor conditions and reducing maintenance requirements. This configuration ultimately supports prolonged equipment life and consistent performance, offering a dependable solution for protecting sensitive electronic components.

The present disclosure described hereinabove has several technical advantages including, but not limited to, an outdoor enclosure for electrical equipment and a method thereof, which: maintains safe internal temperatures even under high thermal loads, reduces the risk of overheating and improving the lifespan of enclosed equipment; prevents the ingress of water, dust, and other contaminants by using advanced sealing and diversion systems, thereby achieving a high standard of environmental protection suitable for various outdoor conditions; facilitates efficient airflow within the enclosure while minimizing noise levels, creating a quieter and more efficient environment for the equipment; withstands harsh weather and environmental stressors, using materials that resist corrosion and wear; aims to simplify assembly, maintenance, and component replacement, reducing both cost and downtime; and captures dust and other particles, maintaining clean airflow and reducing the need for frequent filter replacements.

The methods, systems, devices, graphs, and/or tables discussed herein are examples. Various embodiments may omit, substitute, or add various procedures or components as appropriate. For instance, in alternative embodiments, the methods may be performed in an order different from that described, and/or various stages may be added, omitted, and/or combined. Also, features described with respect to certain embodiments may be combined in various other embodiments. Different aspects and elements of the embodiments may be combined in a similar manner. Also, technology evolves and, thus, many of the elements are examples and do not limit the scope of the disclosure or claims. Additionally, the techniques discussed herein may provide differing results with different types of context awareness classifiers.

Unless defined otherwise, all technical and scientific terms used herein have the same meaning as commonly or conventionally understood. As used herein, the articles "a" and "an" refer to one or to more than one (i.e., to at least one) of the grammatical object of the article. By way of example, "an element" means one element or more than one element. "About" and/or "approximately" as used herein when referring to a measurable value such as an amount, a temporal duration, and the like, encompasses variations of +20% or +10%, +5%, or +0.1% from the specified value, as such variations are appropriate to in the context of the systems, devices, circuits, methods, and other implementations described herein. "Substantially" as used herein when referring to a measurable value such as an amount, a temporal duration, a physical attribute (such as frequency), and the like, also encompasses variations of ±20% or ±10%, ±5%, or ±0.1% from the specified value, as such variations are appropriate to in the context of the systems, devices, circuits, methods, and other implementations described herein.

As used herein, including in the claims, "and" as used in a list of items prefaced by "at least one of" or "one or more of" indicates that any combination of the listed items may be used. For example, a list of "at least one of A, B, and C" includes any of the combinations A or B or C or AB or AC or BC and/or ABC (i.e., A and B and C). Furthermore, to the extent more than one occurrence or use of the items A, B, or C is possible, multiple uses of A, B, and/or C may form part of the contemplated combinations. For example, a list of "at least one of A, B, and C" may also include AA, AAB, AAA, BB, etc.

While illustrative and presently preferred embodiments of the disclosed systems, methods, and/or machine-readable media have been described in detail herein, it is to be understood that the inventive concepts may be otherwise variously embodied and employed, and that the appended claims are intended to be construed to include such variations, except as limited by the prior art. While the principles of the disclosure have been described above in connection with specific apparatuses and methods, it is to be clearly understood that this description is made only by way of example and not as limitation on the scope of the disclosure.

## Claims

1. An outdoor enclosure (100) for electrical equipment (200), said enclosure (100) comprising:
an inlet air diverter door assembly (110), configured to allow fresh air to enter the enclosure while preventing the ingress of water and dust; and
an outlet air diverter door assembly (120), configured to efficiently exhaust hot air generated within the enclosure while minimizing back pressure and noise levels;
wherein the inlet air diverter door assembly (110) and the outlet air diverter door assembly (120) cooperate to maintain the enclosure's internal temperature within operational limits, under a heat load of up to 5.4 kW, and optionally, wherein the operational limits are acceptable operational limits.

2. The outdoor enclosure (100) as claimed in claim 1, wherein the inlet air diverter door assembly (110) comprises:
a series of diverter plates (111) oriented to direct incoming air towards the electrical equipment (200), and channel water jets downward and out of the enclosure to prevent water entry.

3. The outdoor enclosure (100) as claimed in claim 1 or 2, wherein the inlet air diverter door assembly (110) further includes:
a filter element (113) positioned to optimize airflow;
diverter plates (111) that deflect water jets away from the filter element (113), ensuring that the water does not reach the electrical equipment (200).

4. The outdoor enclosure (100) as claimed in claim 3, wherein distance between the filter element (113) and the electrical equipment (200) is less than 75 mm, and the diverter assembly (110) is optimized for high suction pressures created by internal fans (210), and optionally, wherein the high suction pressures created by internal fans (210) are optimized using a computational fluid dynamics (CFD) model to enhance cooling efficiency and minimize pressure drop across the system.

5. The outdoor enclosure (100) as claimed in any preceding claim, wherein the outlet air diverter door assembly (120) comprises:
diverter plates (121) arranged to minimize noise and back pressure;
an outlet hood configured to direct exhaust air directly into the environment, preventing water ingress.

6. The outdoor enclosure (100) as claimed in claim 5, wherein the outlet air diverter door assembly (120) is coupled with a centrifugal fan (130) to enhance airflow and reduce noise, and optionally, wherein the centrifugal fan (130) is integrated with variable-speed control to adapt to dynamic thermal loads, reducing energy consumption under low-heat conditions.

7. The outdoor enclosure (100) as claimed in any preceding claim, wherein the inlet and outlet diverter door assembly (110, 120) are configured without requiring specialized tooling, enabling cost-effective manufacturing, and/or, wherein the inlet air diverter door assembly (110) includes a multi-layer filtration system comprising:
a coarse pre-filter to block larger debris and insects;
a fine particulate filter configured to meet HEPA or equivalent standards for air cleanliness; and
a water-resistant barrier layer to deflect high-pressure water jets.

8. The outdoor enclosure (100) as claimed in claim 5, wherein the outlet air diverter door assembly (120) includes:
an acoustic insulation layer positioned around the exhaust channel to dampen sound waves generated by airflow turbulence; and
aerodynamic fins within the outlet hood to streamline airflow and reduce noise levels.

9. The outdoor enclosure (100) as claimed in any preceding claim, wherein internal layout with the enclosure is configured such that:
critical electrical components (200) are positioned in a central thermal zone for uniform cooling; and
cable management pathways are insulated from airflow channels to prevent thermal interference, and/or, further comprising:
a condensate drainage system integrated into the inlet (110) and outlet (120) air diverter door assembly to collect and expel water that might accumulate within the enclosure during operation.

10. The outdoor enclosure (100) as claimed in claim 2, wherein the diverter plates (111) are coated with a hydrophobic material to enhance water deflection and self-cleaning properties.

11. The outdoor enclosure (100) as claimed in any preceding claim, wherein the enclosure material comprises: a corrosion-resistant alloy or composite material with high thermal conductivity to improve passive heat dissipation.

12. The outdoor enclosure (100) as claimed in claim 5, wherein the outlet air diverter door assembly (120) includes an anti-reverse flow valve to prevent backdraft from environmental conditions such as wind gusts, and/or, wherein the outlet hood is configured with a curved geometry to prevent rainwater pooling and enhance environmental durability.

13. The outdoor enclosure (100) as claimed in claim 3, wherein the inlet air diverter door assembly (110) includes an automated cleaning mechanism using air jets or vibrations to dislodge dust and debris from the filter element (113).

14. A method (300) for cooling an outdoor enclosure housing electrical equipment, comprising:
providing an inlet air diverter door assembly (110) that allows fresh air to enter the enclosure while preventing water and dust ingress;
providing an outlet air diverter door assembly (120) that exhausts hot air generated by the electrical equipment (200) while reducing noise and preventing water ingress; and
maintaining internal temperatures within operational limits under a heat load of up to 5.4 kW, and optionally, wherein the operational limits are safe operational limits.

15. The method (300) as claimed in claim 14, further includes:
arranging the diverter plates (111, 121) within both the inlet (110) and outlet (120) diverter door assemblies in a particular orientation to achieve optimized airflow, reduced noise and back pressure, and protection against water ingress, and optionally, wherein the cooling method further includes:
dynamically adjusting the orientation of the diverter plates (111, 121) using motorized actuators to optimize airflow based on real-time environmental conditions.
